(19) Europäisches Patentamt
European Patent Office
Office européen des brevets

(11) EP 4 786 166 A1

(12) EUROPEAN PATENT APPLICATION
published in accordance with Art. 153(4) EPC

(43) Date of publication:
**05.08.2026 Bulletin 2026/32**

(21) Application number: **24871448.7**

(22) Date of filing: **10.07.2024**

(51) International Patent Classification (IPC):
***B32B 17/10*** *(2006.01)* ***H01L 21/027*** *(2006.01)*

(52) Cooperative Patent Classification (CPC):
**B32B 17/10; H10P 76/00**

(86) International application number:
**PCT/JP2024/024992**

(87) International publication number:
**WO 2025/069644 (03.04.2025 Gazette 2025/14)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **28.09.2023 JP 2023168647**

(71) Applicant: **Nitto Denko Corporation**
**Ibaraki-shi, Osaka 567-8680 (JP)**

(72) Inventors:
- **WATANABE, Ryo**
**Ibaraki-shi, Osaka 567-8680 (JP)**
- **INAGAKI, Junichi**
**Ibaraki-shi, Osaka 567-8680 (JP)**
- **MORISHIMA, Ryota**
**Ibaraki-shi, Osaka 567-8680 (JP)**
- **MIYAMOTO, Seiya**
**Ibaraki-shi, Osaka 567-8680 (JP)**
- **INOUE, Yuta**
**Ibaraki-shi, Osaka 567-8680 (JP)**

(74) Representative: **Hoffmann Eitle**
**Patent- und Rechtsanwälte PartmbB**
**Arabellastraße 30**
**81925 München (DE)**

# (54) LAMINATE, OPTICAL COMPONENT, IMPRINTING METHOD, AND PRODUCTION METHOD FOR OPTICAL COMPONENT

(57) There is provided a laminate including a glass layer, and a resin layer disposed over at least one surface of the glass layer. A ratio (resin layer/glass layer) of an average thickness of the resin layer to an average thickness of the glass layer is less than 0.9.

FIG.5

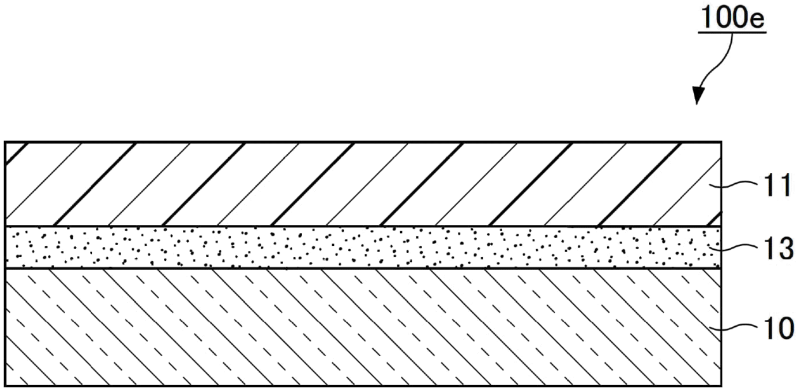




Processed by Luminess, 75001 PARIS (FR)

## Description

### TECHNICAL FIELD

The present invention relates to laminates, optical components, imprinting methods, and production methods for optical components.

### BACKGROUND ART

In recent years, weight and thickness of display elements, such as flat panel displays (FPD, e.g., liquid crystal display elements and organic EL display elements) and solar cells, have been reduced from the viewpoint of transportability, storability, and design, and the display elements are also desired to have improved flexibility. In many cases, a glass substrate has been used for a transparent laminate used in a display element or a solar cell. The glass substrate excels in transparency, solvent resistance, gas barrier properties, and heat resistance. However, when an attempt is made to reduce weight and thickness of a glass material constituting a glass substrate, although a certain degree of flexibility is exhibited, the achieved flexibility is not sufficient, and impact resistance becomes insufficient, which causes a problem of difficulty in handling.

In order to improve handling of a thin glass substrate, a substrate in which a resin layer is formed on the glass surface is disclosed (see, for example, Patent Document 1). However, a laminate having sufficient dimensional stability and flexibility has not been obtained using these technologies.

Meanwhile, a nanoimprint technology used for display elements, such as flat panel displays (FPD; e.g., liquid crystal display elements and organic EL display elements) and solar cells, is a method of transferring a component in a nanometer size to a micrometer size, which cannot be achieved by injection molding, to a substrate using a mold, and there are two types of imprint methods, which include an ultra-violet (UV) nanoimprint method and a thermal nanoimprint method. The UV nanoimprint method is a method in which UV light is applied to a UV curable resin poured into a mold to cure and shape the UV curable resin. The thermal nanoimprint method is a method in which heat and pressure are applied to a thermoplastic resin poured into a mold to shape the thermoplastic resin. The UV nanoimprint method is a method with a short curing time, which is about several seconds, and of high productivity.

For example, in the case where an optical component is produced by the UV nanoimprint method, there is proposed a method in which a photosensitive resin layer, such as a UV curable resin, is formed on a resin substrate, such as a polyethylene terephthalate (PET) film, and the photosensitive resin layer is exposed to light through a mask pattern to cure the photosensitive resin layer, thereby forming a molded product on the resin substrate (see Patent Document 2).

### CITATION LIST

#### PATENT DOCUMENT

Patent Document 1: Japanese Unexamined Patent Application Publication No. H11-329715
Patent Document 2: International Publication No. WO 01/22165

### Summary of the Invention

#### Technical Problem

The optical members described in Patent Documents 1 and 2 have a problem that a molded product is warped due to curing shrinkage occurring when the UV curable resin on the resin substrate, such as a PET film, is cured, or due to expansion and shrinkage of the resin substrate caused by heat applied during use.

An aspect of the present invention aims to solve the various problems existing in the related art and to provide a laminate that can inhibit warping.

#### SOLUTION TO THE PROBLEM

According to an aspect of the present invention, a laminate includes a glass layer and a resin layer disposed over at least one surface of the glass layer. A ratio (resin layer/glass layer) of an average thickness of the resin layer to an average thickness of the glass layer is less than 0.9.

EFFECTS OF THE INVENTION

According to an aspect of the present invention, there can be provided a laminate that can inhibit warping.

BRIEF DESCRIPTION OF THE DRAWING

[Fig. 1] Fig. 1 is a schematic cross-sectional view illustrating an example of a laminate of an embodiment of the present invention.
[Fig. 2] Fig. 2 is a schematic cross-sectional view illustrating another example of the laminate of the embodiment of the present invention.
[Fig. 3] Fig. 3 is a schematic cross-sectional view illustrating another example of the laminate of the embodiment of the present invention.
[Fig. 4] Fig. 4 is a schematic cross-sectional view illustrating another example of the laminate of the embodiment of the present invention.
[Fig. 5] Fig. 5 is a schematic cross-sectional view illustrating another example of the laminate of the embodiment of the present invention.
[Fig. 6] Fig. 6 is a schematic top view for describing a measuring method when distortion of the laminate of the embodiment of the present invention is measured by digital image correlation (DIC analysis).
[Fig. 7A] Fig. 7A is an explanatory diagram illustrating an example of a speckle pattern on an exposed surface (top surface) of the laminate before heating, when the distortion of the laminate of the embodiment of the present invention is measured by digital image correlation (DIC analysis).
[Fig. 7B] Fig. 7B is an explanatory diagram illustrating an example of a speckle pattern on the exposed surface (top surface) of the laminate after heating, when the distortion of the laminate of the embodiment of the present invention is measured by digital image correlation (DIC analysis).
[Fig. 8] Fig. 8 includes photographs depicting the distortion in the images of the laminates after heating based on a color meter at the measurement of the distortion of the laminates of Examples 1 to 5 and Comparative Example 1 by digital image correlation (DIC analysis).

DETAILED DESCRIPTION OF THE EMBODIMENTS

Embodiments of the present invention will be described in detail hereinafter. The embodiments are not limited by the following description, and may be appropriately changed without departing from the gist of the present invention. In addition, in the present specification, "to" indicating a numerical range means that numerical values described before and after the "to" are included as a lower limit and an upper limit, respectively, unless otherwise specified.
In addition, when an embodiment of the present invention is described with reference to drawings, the same reference numerals are given to the same components in the drawings, and redundant description may be omitted. The number, position, size, shape, and the like of the constituent components are not limited to those in the embodiment of the present invention, and can be set to the number, position, size, shape, and the like preferable for implementing the present invention.

(Laminate)

The laminate of the embodiment of the present invention includes a glass layer and a resin layer disposed over at least one surface of the glass layer. The laminate further includes other layers as necessary. In the laminate of the embodiment of the present invention, a ratio (resin layer/glass layer) of an average thickness of the resin layer to an average thickness of the glass layer is less than 0.9. Thus, the laminate of the embodiment of the present invention can inhibit warping, and can particularly suitably inhibit warping caused due to heating.

[Average thickness ratio (resin layer/glass layer)]

In the laminate of the embodiment of the present invention, the ratio (resin layer/glass layer) of the average thickness of the resin layer to the average thickness of the glass layer is less than 0.9, preferably 0.5 or less, more preferably 0.4 or less, and yet more preferably 0.3 or less. When the average thickness ratio (resin layer/glass layer) is 0.9 or greater, warping of the laminate occurs. Conversely, when the average thickness ratio (resin layer/glass layer) is less than 0.9, warping of the laminate can be inhibited, and moreover, favorable flexibility of the laminate can be obtained.
In the embodiment of the present invention, when each of the glass layer and the resin layer is a multilayer stack,

each of "the average thickness of the glass layer" and "the average thickness of the resin layer" means a sum of average thickness values of the multiple layers (total thickness).

In the present embodiment, the "average thickness" means an average value of thickness measured at randomly selected 3 points on a target layer. The thickness of each of the layers can be measured by a film thickness measuring device known in the related art (e.g., R1-205, PEACOCK (registered trademark), manufactured by (OZAKI MFG. CO., LTD.)).

[Inhibition of warping]

Inhibition of warping of the laminate of the embodiment of the present invention can be measured by digital image correlation (DIC analysis). Specifically, a spray coating material (e.g., aqueous lacquer spray, manufactured by SUNDAY PAINT CO., LTD.) is applied to an exposed surface of the resin layer of the laminate of the embodiment of the present invention by spray coating to form a random granular pattern (may be referred to as a "speckle pattern" hereinafter) on the exposed surface of the resin layer of the laminate. The distortion of the laminate in a z direction is calculated from the change in the speckle pattern before and after heating the laminate at 60°C.

Fig. 7A illustrates an example of the speckle pattern on the exposed surface (top surface) of the resin layer of the laminate before heating, when the distortion of the laminate of the embodiment of the present invention is measured by DIC analysis. In addition, Fig. 7B illustrates an example of the speckle pattern on the exposed surface (top surface) of the resin layer of the laminate after heating, when the distortion of the laminate of the embodiment of the present invention is measured by DIC analysis. Point A and Point B in Fig. 7A indicate adjacent points in the speckle pattern. The distance connecting between Point A and Point B with a straight line is determined as D. In addition, Point A and Point B' in Fig. 7B indicate the adjacent points in the speckle pattern after heating, and indicate that, when Point A of Fig. 7A is set as a starting point, Point B is moved to the position of Point B' of Fig. 7B due to expansion of the resin layer. The distance connecting between the point A and the point B' with a straight line is determined with D'. In the case where the resin layer of the laminate is distorted after heating, the exposed surface (top surface) of the resin layer expands or shrinks in the x direction and y direction. In the case where the resin layer of the laminate is expanded by heating (i.e., distance D < distance D'), the resin layer of the laminate warps, and the position of Point B of Fig. 7A moves to the position of Point B' of Fig. 7B. Therefore, the distance D before heating is extended to the distance D' after heating. Thus, the distortion of the laminate of the embodiment of the present invention can be calculated according to the following equation (1), in which a difference between the distance D and the distance D' is determined as $\Delta D$. In the case where the resin layer of the laminate shrinks by heating (i.e., distance D > distance D'), the moving direction of Point B' is directed toward Point A along D illustrated with a straight line. In this case, the distortion of the laminate of the embodiment of the present invention can be similarly calculated according to the following equation (1). Both the x direction and the y direction are directions perpendicular to the thickness direction of the laminate. The x direction and the y direction may be a machine direction of the resin of the resin layer (may be also referred to as a "flow direction" or "MD direction") and a direction perpendicular to the MD direction (may be also referred to as a "width direction" or "TD direction").

$$\text{Distortion (\%)} = \Delta D/D \times 100 \qquad \text{Equation (1)}$$

Next, a displacement in the z direction is calculated from the distortion calculated according to the equation (1). In the embodiment of the present invention, the z direction is a direction orthogonal to a plane defined by the x direction and the y direction, i.e., the thickness direction of the laminate of the embodiment of the present invention. Fig. 6 is a schematic top view for describing a measuring method when the distortion of the laminate of the embodiment of the present invention is measured by DIC analysis. As illustrated in Fig. 6, the surface of the laminate on which the speckle pattern is provided (region indicated with the solid line in Fig. 6) is divided into 9 as indicated with the perforated lines in Fig. 6, the maximum value of the displacement in the z direction is calculated in each of 9 divided values to obtain 9 maximum values, and the maximum value among the 9 maximum values of the displacement in the z direction is determined as the maximum z-displacement of a measuring sample at 60°C. The "maximum z-displacement" calculated in the above-described manner is determined as a "maximum thermal warping" in the embodiment of the present invention. The larger maximum thermal warping means the larger warping of the laminate caused by heating. The distortion in the x direction and the y direction, and the displacement in the z direction can be measured by a deformation measurement/strain analysis device known in the related art (e.g., StarinMaster, manufactured by LaVision).

The absolute value of the maximum thermal warping of the laminate in the thickness direction of the laminate at 60°C, when the laminate of the embodiment of the present invention is measured by a digital image correlation, is not particularly limited, and may be appropriately selected according to the intended purpose. The absolute value of the maximum thermal warping is preferably less than 2 mm, more preferably 0.5 mm or less, yet more preferably 0.3 mm or less, and particularly preferably 0.1 mm or less. When the absolute value of the maximum thermal warping in the thickness

direction of the laminate is less than 2 mm, the laminate of the embodiment of the present invention can be suitably used for a substrate for imprint.

[Thickness]

An average thickness of the laminate of the embodiment of the present invention is not particularly limited, and may be appropriately selected according to the intended purpose. The average thickness of the laminate is preferably 450 μm or less, more preferably 380 μm or less, yet more preferably 300 μm or less, yet further preferably 200 μm or less, particularly preferably 150 μm or less, and most preferably 80 μm to 130 μm. In the embodiment of the present invention, the average thickness of the laminate means a sum (total thickness) of the average thickness values of all the layers in the laminate of the embodiment of the present invention. Since the laminate of the embodiment of the present invention includes the resin layer, the thickness of the glass layer can be significantly reduced compared with a glass substrate of the related art. Specifically, even a thin resin layer can contribute to improvement in impact resistance and toughness, and therefore the laminate of the embodiment of the present invention including the resin layer is light in weight with a small thickness, has excellent impact resistance, and can inhibit warping.

[Transmittance]

The transmittance of the laminate of the embodiment of the present invention at a wavelength of 550 nm is not particularly limited, and may be appropriately selected according to the intended purpose. The transmittance of the laminate is preferably 80% or greater, more preferably 85% or greater, and yet more preferably 90% or greater. The transmittance of the laminate at a wavelength of 550 nm can be measured by a spectrophotometer (e.g., U-4100, manufactured by Hitachi, Ltd.).

After subjecting the laminate of the embodiment of the present invention to a heat treatment at 180°C for 2 hours, a reduction in transmittance of the laminate is preferably within 5%. Applicable transmittance of the laminate can be suitably secured with such a reduction ratio even when a heating treatment, which is necessary in an imprint process, is performed on the laminate.

[Surface roughness Ra]

The surface roughness Ra of the laminate of the embodiment of the present invention (substantially, the surface roughness Ra of the resin layer or other layers) is not particularly limited, and may be appropriately selected according to the intended purpose. The surface roughness Ra of the laminate is preferably 50 nm or less, more preferably 30 nm or less, and yet more preferably 10 nm or less.

[Coefficient of linear thermal expansion]

The coefficient of linear thermal expansion of the laminate of the embodiment of the present invention is not particularly limited, and may be appropriately selected according to the intended purpose. The coefficient of linear thermal expansion of the laminate is preferably 15 ppm/°C or less, more preferably 10 ppm/°C or less, and yet more preferably 1 ppm/°C to 10 ppm/°C. Since the laminate of the embodiment of the present invention includes the glass layer, the laminate exhibits excellent dimensional stability (for example, the coefficient of linear thermal expansion in the above-described range). More specifically, in addition to the glass layer itself being rigid, dimensional variation of the resin layer can be inhibited by constraining the resin layer with the glass layer. As a result, the laminate exhibits excellent dimensional stability as a whole, leading to inhibition of warping.

<Glass layer>

A material constituting the glass layer in the laminate of the embodiment of the present invention is not particularly limited. The material is preferably inorganic glass.

The classification of the inorganic glass according to the composition of the inorganic glass is not particularly limited, and may be appropriately selected according to the intended purpose. Examples of the inorganic glass classified according to the composition include soda-lime glass, borate glass, aluminosilicate glass, quartz glass, and the like. The above examples of the inorganic glass may be used alone or in combination of two or more.

In addition, the classification of the inorganic glass according to an alkali component is not particularly limited, and may be appropriately selected according to the intended purpose. Examples of the inorganic glass classified according to the alkali component include alkali-free glass, low alkali glass, and the like.

Examples of an alkali metal component in the inorganic glass include $Na_2O$, $K_2O$, $Li_2O$, and the like. An amount of

the alkali metal component in the inorganic glass is not particularly limited, and may be appropriately selected according to the intended purpose. The amount of the alkali metal component is preferably 15 percent by mass or less, and more preferably 10 percent by mass or less, relative to a total mass of the inorganic glass.

The shape of the glass layer is not particularly limited, and may be appropriately selected from any shape, but is preferably a plate shape.

In the laminate of the embodiment of the present invention, the glass layer may be a single layer or a multilayer stack, but is preferably a single layer.

An average thickness of the glass layer is not particularly limited, and may be appropriately selected according to the intended purpose, as long as the average thickness ratio (resin layer/glass layer) becomes less than 0.9. The average thickness of the glass layer is preferably 200 μm or less, more preferably 20 μm to 200 μm, and yet more preferably 50 μm to 100 μm. Since the laminate of the embodiment of the present invention includes the resin layer on at least one surface of the glass layer, when the thickness of the glass layer is 200 μm or less, favorable flexibility can be imparted to the laminate; and when the thickness of the glass layer is 20 μm or greater, favorable impact resistance can be imparted to the laminate.

The transmittance of the glass layer at a wavelength of 550 nm is not particularly limited, and may be appropriately selected according to the intended purpose. The transmittance of the glass layer is preferably 85% or greater, more preferably 90% or greater, and yet more preferably 95% or greater. The transmittance of the glass layer at a wavelength of 550 nm can be measured by a spectrophotometer (for example, U-4100, manufactured by Hitachi, Ltd.).

A method of forming the glass layer is not particularly limited, and may be appropriately selected according to the intended purpose. Examples of the method include a method in which a mixture including a main raw material, such as silica, alumina, or the like, a defoaming agent, such as mirabilite, antimony oxide, or the like, and a reducing agent, such as carbon, is melted at a temperature of 1,400°C to 1,600°C, followed by forming the mixture into a thin film, and the melted mixture is cooled to form a glass layer formed of inorganic glass. A method of forming the glass layer into the thin plate (e.g., 200 μm or less) is not particularly limited, and may be appropriately selected according to the intended purpose. Examples of the method include a slot down draw method, a fusion method, a float method, and the like. The glass layer formed into the plate by any of the above methods may be subjected to chemical polishing with a solvent, such as hydrofluoric acid, as necessary, for reducing a thickness or increasing smoothness. The glass layer may be subjected to a surface treatment.

As the glass layer, a commercially available glass layer may be used, or commercially available inorganic glass whose thickness may be reduced to a desired thickness by polishing may be used. Examples of the commercially available inorganic glass include: 7059, 1737, and EAGLE2000 (all manufactured by Corning Incorporated); AN100 (manufactured by AGC Inc.); NA-35 (manufactured by NH Techno Glass Co., Ltd.); OA-10G (manufactured by Nippon Electric Glass Co., Ltd.); D263 (registered trademark) and AF45 (registered trademark) (all manufactured by SCHOTT AG); and the like.

<Resin layer>

A material constituting the resin layer in the laminate of the embodiment of the present invention is not particularly limited, and may be appropriately selected according to the intended purpose, as long as the material includes a resin. The material constituting the resin layer may further include other components, as necessary.

<<Resin>>

The resin included in the resin layer is not particularly limited, and may be appropriately selected according to the intended purpose. Examples of the resin include thermoplastic resins, curable resins that are cured by heat or active energy rays, and the like. The above resins may be used alone or in combination of two or more. Among the above resins, the resin layer preferably includes a thermoplastic resin.

Specific examples of the resin included in the resin layer include: polyether sulfone-based resins; polycarbonate-based resins; epoxy-based resins; acrylic resins; polyester-based resins, such as polyethylene terephthalate and polyethylene naphthalate; polyolefin-based resins; cycloolefin-based resins, such as norbornene-based resins; polyimide-based resins; polyamide-based resins; polyimide amide-based resins; polyarylate-based resins; polysulfone-based resins; polyether imide-based resins; and the like.

Among the above resins, the resin layer preferably includes at least one selected from the group consisting of a thermoplastic resin (A), a thermoplastic resin (B), and a thermoplastic resin (C), where the thermoplastic resin (A) includes at least one repeating unit selected from the group consisting of a repeating unit represented by the following general formula (1) and a repeating unit represented by the following general formula (2), the thermoplastic resin (B) includes at least one repeating unit represented by the following general formula (3), and the thermoplastic resin (C) includes a hydroxyl group at a terminal.

-Thermoplastic resin (A)-

The thermoplastic resin (A) is a thermoplastic resin including at least one repeating unit selected from the group consisting of a repeating unit represented by the following general formula (1) and a repeating unit represented by the following general formula (2). Since the thermoplastic resin (A) is included in the resin layer, the resin layer having excellent adhesion to the glass layer or other layers to be in contact with the resin layer (e.g., a coupling agent layer and an adhesive layer) and excellent toughness can be obtained. As a result, the laminate in which cracks are less likely to develop during curing can be obtained. The thermoplastic resin (A) having excellent adhesion to the glass layer or other layers to be in contact with other layers is strongly constrained by the glass layer, thereby reducing dimensional variation. As a result, the laminate that includes the resin layer including the thermoplastic resin (A) exhibits excellent dimensional stability, and more favorably inhibits warping.

[Chem. 1]

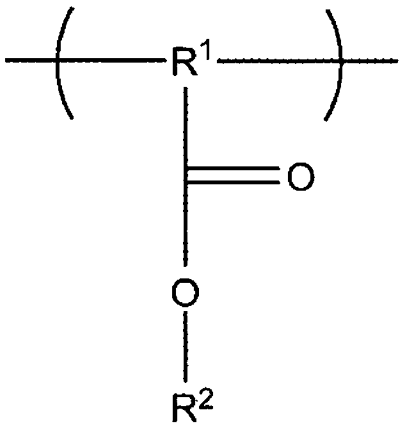

General Formula (1)

In the general formula (1), $R^1$ is a substituted or unsubstituted aromatic hydrocarbon group with 6 to 24 carbon atoms, an alicyclic hydrocarbon group with 4 to 14 carbon atoms, or a straight-chain or branched chain aliphatic hydrocarbon group with 1 to 8 carbon atoms; and $R^2$ is a substituted or unsubstituted aromatic hydrocarbon group with 6 to 24 carbon atoms, a straight-chain or branched-chain aliphatic hydrocarbon group with 1 to 8 carbon atoms, an aliphatic hydrocarbon group with 5 to 12 carbon atoms, or a hydrogen atom.

In the general formula (1), $R^1$ is preferably a substituted or unsubstituted aromatic hydrocarbon group with 6 to 20 carbon atoms, an alicyclic hydrocarbon group with 4 to 12 carbon atoms, or a straight-chain or branched-chain aliphatic hydrocarbon group with 1 to 6 carbon atoms, and more preferably a substituted or unsubstituted aromatic hydrocarbon group with 6 to 18 carbon atoms, an alicyclic hydrocarbon group with 5 to 10 carbon atoms, or a straight-chain or branched-chain aliphatic hydrocarbon group with 1 to 4 carbon atoms.

In the general formula (1), $R^2$ is preferably a substituted or unsubstituted aromatic hydrocarbon group with 6 to 20 carbon atoms, a straight-chain or branched-chain aliphatic hydrocarbon group with 1 to 6 carbon atoms, an alicyclic hydrocarbon group with 5 to 10 carbon atoms, or a hydrogen atom.

[Chem. 2]

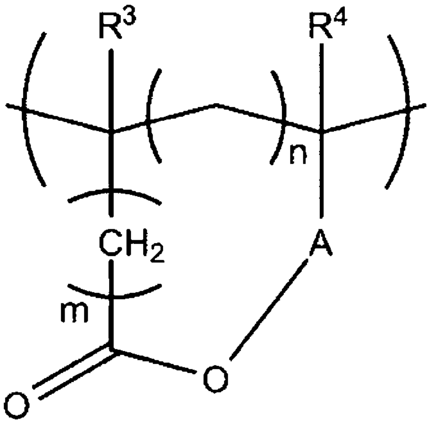

General Formula (2)

In the general formula (2), $R^3$ and $R^4$ are each independently a straight-chain or branched-chain aliphatic hydrocarbon group with 1 to 8 carbon atoms, a hydrogen atom, or an alicyclic hydrocarbon group with 5 to 12 carbon atoms; A is a carbonyl group or a straight-chain or branched-chain aliphatic hydrocarbon group with 1 to 8 carbon atoms; m is an integer of 0 to 8; and n is an integer of 0 to 4. The "each independently" means that $R^3$ and $R^4$ may be same or different.

In the general formula (2), $R^3$ and $R^4$ are preferably each independently a straight-chain or branched-chain aliphatic hydrocarbon group with 1 to 5 carbon atoms, a hydrogen atom, or an alicyclic hydrocarbon group with 5 to 10 carbon atoms, and more preferably a straight-chain or branched-chain aliphatic hydrocarbon group with 1 to 4 carbon atoms, a hydrogen atom, or an alicyclic hydrocarbon group with 5 to 8 carbon atoms.

In the general formula (2), A is preferably a carbonyl group, or a straight-chain or branched-chain aliphatic hydrocarbon group with 1 to 6 carbon atoms, and more preferably a carbonyl group, or a straight-chain or branched-chain aliphatic hydrocarbon group with 1 to 4 carbon atoms.

In the general formula (2), m is preferably an integer of 0 to 6, and more preferably an integer of 0 to 3.

In the general formula (2), n is preferably an integer of 0 to 2.

The degree of polymerization of the thermoplastic resin (A) is not particularly limited, and may be appropriately selected according to the intended purpose. The degree of polymerization of the thermoplastic resin (A) is preferably 10 to 6,000, more preferably 20 to 5,000, and yet more preferably 50 to 4,000.

Specific examples of the thermoplastic resin (A) include styrene-maleic anhydride copolymers, ester group-containing cycloolefin polymers, and the like. The above thermoplastic resins (A) may be used alone or in combination of two or more.

-Thermoplastic resin (B)-

The thermoplastic resin (B) is a thermoplastic resin including at least one repeating unit represented by the following general formula (3). Since the resin layer includes the thermoplastic resin (B), the resin layer having excellent adhesion to the glass layer or other layers to be in contact with the resin layer (e.g., a coupling agent layer and adhesive layer) and excellent toughness can be obtained. As a result, the laminate that is less likely to develop cracks during cutting can be obtained. The thermoplastic resin (B) having excellent adhesion to the glass layer or other layers to be in contact with the resin layer is strongly constrained by the glass layer, thereby reducing dimensional variation. As a result, the laminate that includes the resin layer including the thermoplastic resin (B) exhibits excellent dimensional stability, and more favorably inhibits wrapping.

[Chem. 3]

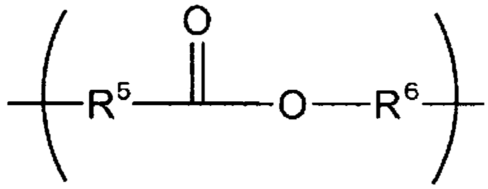

General Formula (3)

In the general formula (3), $R^5$ is a substituted or unsubstituted aromatic hydrocarbon group with 6 to 24 carbon atoms, a straight-chain or branched-chain aliphatic hydrocarbon group with 1 to 8 carbon atoms, an alicyclic hydrocarbon group with 4 to 14 carbon atoms, or an oxygen atom; and $R^6$ is a substituted or unsubstituted aromatic hydrocarbon group with 6 to 24 carbon atoms, a straight-chain or branched-chain aliphatic hydrocarbon group with 1 to 8 carbon atoms, an aliphatic hydrocarbon group with 5 to 12 carbon atoms, or a hydrogen atom.

In the general formula (3), $R^5$ is preferably a substituted or unsubstituted aromatic hydrocarbon group with 6 to 20 carbon atoms, a straight-chain or branched-chain hydrocarbon group with 1 to 6 carbon atoms, an alicyclic hydrocarbon group with 4 to 12 carbon atoms, or an oxygen atom, and more preferably a substituted or unsubstituted aromatic hydrocarbon group with 6 to 18 carbon atoms, a straight-chain or branched-chain aliphatic hydrocarbon group with 1 to 4 carbon atoms, an alicyclic hydrocarbon group with 5 to 10 carbon atoms, or an oxygen atom.

In the general formula (3), $R^6$ is preferably a substituted or unsubstituted aromatic hydrocarbon group with 6 to 20 carbon atoms, a straight-chain or branched-chain hydrocarbon group with 1 to 6 carbon atoms, an alicyclic hydrocarbon group with 5 to 10 carbon atoms, or a hydrogen atom.

The degree of polymerization of the thermoplastic resin (B) is not particularly limited, and may be appropriately selected according to the intended purpose. The degree of polymerization of the thermoplastic resin (B) is preferably 10 to 6,000, more preferably 20 to 5,000, and yet more preferably 50 to 4,000.

Specific examples of the thermoplastic resin (B) include polyacrylate, polyester, polycarbonate, and the like. The above thermoplastic resins (B) may be used alone or in combination of two or more.

-Thermoplastic resin (C)-

The thermoplastic resin (C) is a thermoplastic resin including a hydroxyl group at a terminal. The thermoplastic resin (C) is preferably used when the laminate includes a coupling agent layer formed using an epoxy-group terminated coupling agent.

Specific examples of the thermoplastic resin (C) include thermoplastic resins obtained by modifying terminals of polyimide, polyimide amide, polyether sulfone, polyether imide, polysulfone, polyarylate, polycarbonate, and the like with hydroxyl groups. The above thermoplastic resins may be used alone or in combination of two or more. By using the above thermoplastic resin (C), the resin layer having excellent adhesion to a coupling agent layer formed with the epoxy-group terminated coupling agent, and excellent toughness can be obtained. As a result, the laminate that is less likely to develop cracks during cutting can be obtained. In addition, the thermoplastic resin (C) having excellent adhesion to the coupling agent layer formed using the epoxy-group terminated coupling agent is strongly constrained by the glass layer, thereby reducing dimensional variation. As a result, the laminate that includes the resin layer including the thermoplastic resin (C) exhibits excellent dimensional stability and more favorably inhibits warping. Any appropriate method may be used for the terminal hydroxyl group modification. The details of the epoxy-group terminated coupling agent will be described later.

The degree of polymerization of the thermoplastic resin (C) is not particularly limited, and may be appropriately selected according to the intended purpose. The degree of polymerization of the thermoplastic resin (C) is preferably 90 to 6,200, more preferably 130 to 4,900, and yet more preferably 150 to 3,700.

The weight average molecular weight of the thermoplastic resin (C) is not particularly limited, and may be appropriately selected according to the intended purpose. The weight average molecular weight of the thermoplastic resin (C) based on polyethylene oxide conversion is preferably $2.0 \times 10^4$ to $150 \times 10^4$, more preferably $3 \times 10^4$ to $120 \times 10^4$, and yet more preferably $3.5 \times 10^4$ to $90 \times 10^4$. When the weight average molecular weight of the thermoplastic resin (C) is $2.0 \times 10^4$ or greater, toughness is imparted to the resin layer, which reinforces the glass layer. When the weight average molecular weight of the thermoplastic resin (C) is $150 \times 10^4$ or less, the viscosity of the thermoplastic resin (C) does not become too high, and therefore excellent handling properties can be obtained.

The terminal hydroxyl group of the thermoplastic resin (C) is not particularly limited, and may be appropriately selected according to the intended purpose. The terminal hydroxyl group of the thermoplastic resin (C) is preferably a phenolic hydroxyl group. In the case of the thermoplastic resin (C) including a phenolic hydroxyl group, the resin layer and the coupling agent layer formed using the epoxy-group terminated coupling agent can be strongly adhered.

The amount of the terminal hydroxyl group in the thermoplastic resin (C) is not particularly limited, and may be appropriately selected according to the intended purpose. The amount of the terminal hydroxyl group is preferably 0.3 or greater, and more preferably 0.5 to 2.0 relative to 100 in the degree of polymerization of the thermoplastic resin. When the amount of the terminal hydroxyl group in the thermoplastic resin (C) is 0.3 or greater relative to 100 in the degree of polymerization of the thermoplastic resin (C), the thermoplastic resin having excellent reactivity with the epoxy-group terminated coupling agent can be obtained.

<<Other components>>

Other components in the resin layer are not particularly limited, and may be appropriately selected according to the intended purpose. Examples of the other components include various additives, such as diluents, anti-aging agents, modifiers, surfactants, dyes, pigments, discoloration inhibitors, ultraviolet absorbers, softening agents, stabilizers, plasticizers, defoaming agents, reinforcing agents, and the like. Types, a number, and an amount of the additives included in the resin layer are not particularly limited, and may be appropriately selected according to the intended purpose.

In the case where the resin layer includes the thermoplastic resin (C), the resin layer preferably further includes at least one selected from the group consisting of imidazoles, epoxies, and oxetanes. When the resin layer includes at least one selected from the group consisting of imidazoles, epoxies, and oxetanes, the resin layer and the glass layer provided with the epoxy-group terminated coupling agent layer can be stably adhered, and therefore a laminate can be obtained at a high yield.

-Imidazoles-

Examples of the imidazoles include 2-methylimidazole, 2-undecylimidazole, 2-heptadecylimidazole, 1,2-dimethylimidazole, 2-ethyl-4-methylimidazole, 2-phenylimidazole, 2-phenyl-4-methylimidazole, 1-benzyl-2-methylimidazole, 1-benzyl-2-phenylimidazole, 1-cyanoethyl-2-methylimidazole, 1-cyanoethyl-2-undecylimidazole, 1-cyanoethyl-2-ethyl-4-methylimidazole, 1-cyanoethyl-2-phenylimidazole, epoxyimidazole adducts, 2,3-dihydro-1H-pyrrolo[1,2-a]benzimidazole, 1-dodecyl-2-methyl-3-benzylimidazolium chloride, 2-phenyl-4,5-dihydroxymethylimidazole, 2-phenyl-4-methyl-5-hydroxymethylimidazole, 1-cyanoethyl-2-undecylimidazolium trimellitate, 1-cyanoethyl-2-phenylimidazoliumtrimellitate, 2,4-diamino-6-[2'-methylimidazolyl-(1')]-ethyl-s-triazine, 2,4-diamino-6-[2'-undecylimidazolyl-(1')]-ethyl-s-triazine, 2,4-diamino-6-[2'-ethyl-4'-methylimidazolyl-(1')]-ethyl-s-triazine, and the like. The above imidazoles may be used alone or in combination of two or more.

An amount of the imidazoles is not particularly limited, and may be appropriately selected according to the intended purpose. The amount of the imidazoles is preferably 0.5 percent by mass to 5 percent by mass, and more preferably 1 percent by mass to 4 percent by mass, relative to a total mass of the thermoplastic resin (C).

-Epoxies-

The epoxies are not particularly limited as long as the epoxies include an epoxy group in molecules of the epoxies. Examples of the epoxies include: bisphenol epoxies, such as bisphenol A epoxies, bisphenol F epoxies, bisphenol S epoxies, and hydrogenated product of the foregoing; novolac epoxies, such as phenol novolac epoxies and cresol novolac epoxies; nitrogen ring-containing epoxies, such as triglycidyl isocyanurate epoxies and hydantoin epoxies; alicyclic epoxies; aliphatic epoxies; aromatic epoxies, such as naphthalene epoxies and biphenyl epoxies; glycidyl epoxies, such as glycidyl ether epoxies, glycidyl amine epoxies, and glycidyl ester epoxies; dicycloepoxies, such as dicyclopentadiene epoxies; ester epoxies; ether ester epoxies; modified epoxy-based resins of the foregoing; and the like. The above epoxies may be used alone or in combination of two or more. Among the above epoxies, the epoxies are preferably a bisphenol A epoxy-based resin, an alicyclic epoxy-based resins, a nitrogen ring-containing epoxy-based resin, or a glycidyl epoxy-based resin.

An amount of the epoxies is not particularly limited, and may be appropriately selected according to the intended purpose. The amount of the epoxies is preferably 1 percent by mass to 15 percent by mass, and more preferably 3 percent by mass to 10 percent by mass, relative to a total mass of the thermoplastic resin (C).

-Oxetanes-

The oxetanes are not particularly limited, and may be appropriately selected according to the intended purpose. The oxetanes are preferably at least one selected from the group consisting of a compound represented by the following general formula (4), a compound represented by the following general formula (5), and a compound represented by the following general formula (6).

[Chem. 4]

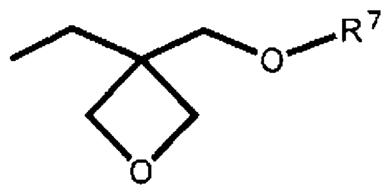

General Formula (4)

In the general formula (4), $R^7$ is a hydrogen atom, an alicyclic hydrocarbon group, a phenyl group, a naphthyl group, or an aliphatic hydrocarbon group with 1 to 10 carbon atoms.

[Chem. 5]

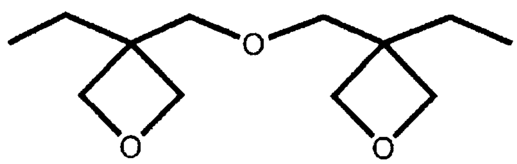

General Formula (5)

[Chem. 6]

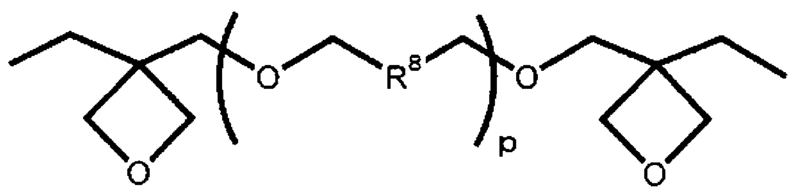

General Formula (6)

In the general formula (6), $R^8$ is an alicyclic hydrocarbon group, a phenyl group, a naphthyl group, or an aliphatic hydrocarbon group with 1 to 10; and p is an integer of 1 to 5.

Specific examples of the oxetanes include 3-ethyl-3-hydroxymethyloxetane (oxetane alcohol), 2-ethylhexyloxetane, xylene bisoxetane, 3-ethyl-3(((3-ethyloxetan-3-yl)methoxy)methyl)oxetane, and the like. The above oxetanes may be used alone or in combination of two or more.

An amount of the oxetanes is not particularly limited, and may be appropriately selected according to the intended purpose. The amount of the oxetanes is preferably 0.5 percent by mass to 10 percent by mass, and more preferably 1

percent by mass to 5 percent by mass, relative to a total mass of the thermoplastic resin (C).

The resin layer may be a single layer or a multilayer stack. In one embodiment, the resin layer is a multilayer stack, which includes a layer including the thermoplastic resin (A) and a layer including a thermoplastic resin that does not include repeating units represented by the general formula (1) and the general formula (2). In another embodiment, the resin layer is a multilayer stack, which includes a layer including the thermoplastic resin (B) and a layer including a thermoplastic resin that does not include a repeating unit represented by the general formula (3). When the resin layer is the multilayer stack as described above, a laminate having excellent mechanical strength and heat resistance can be obtained.

A glass transition temperature (Tg) of the resin included in the resin layer is not particularly limited, and may be appropriately selected according to the intended purpose. The glass transition temperature (Tg) of the resin included in the resin layer is preferably 150°C to 350°C, more preferably 180°C to 320°C, and yet more preferably 210°C to 290°C. When the glass transition temperature (Tg) of the resin included in the resin layer is 150°C to 350°C, a laminate having excellent heat resistance can be obtained.

The resin layer preferably further has chemical resistance. Specifically, the resin layer preferably has chemical resistance with respect to a solvent used for a washing step, a resist stripping step, or the like in an imprint process. Examples of the solvent used for the washing step or the like in the imprint process include isopropyl alcohol, acetone, dimethyl sulfoxide (DMSO), N-methylpyrrolidone (NMP), and the like.

An average thickness of the resin layer is not particularly limited, and may be appropriately selected according to the intended purpose, as long as the average thickness ratio (resin layer/glass layer) becomes less than 0.9. The average thickness of the resin layer is preferably less than 180 μm, more preferably 5 μm to 100 μm, yet more preferably 5 μm to 40 μm, and particularly preferably 5 μm to 30 μm. When the average thickness of the resin layer is less than 180 μm, warping of the laminate can be suitably inhibited. In the case where the resin layer is disposed over both surfaces of the glass layer, or in the case where the resin layer is formed of multiple layers, the resin layers may have a same thickness or different thickness, but preferably have a same thickness. In the case where the resin layer is disposed over both surfaces of the glass layer, or in the case where the resin layer is formed of multiple layers, the resin layers may be formed of a same resin or a resin having the same properties, or may be formed of different resins, but are preferably formed of a same resin. Accordingly, the resin layers are particularly preferably formed of the same resin to have the same thickness. With such a configuration, thermal stress is evenly applied on the both surfaces of the glass layer when a heat treatment is performed, and therefore warping is very unlikely to occur.

The elastic modulus of the resin layer at 25°C is not particularly limited, and may be appropriately selected according to the intended purpose. The elastic modulus of the resin layer at 25°C is preferably 1.5 GPa to 10 GPa, more preferably 1.7 GPa to 8 GPa, and yet more preferably 1.9 GPa to 6 GPa. When the elastic modulus of the resin layer at 25°C is 1.5 GPa to 10 GPa, even though the glass layer is thin, the resin layer mitigates local stress applied to a defect in a tearing direction during deformation of the resin layer, and therefore cracks or breakages in the glass layer are less likely to occur.

The transmittance of the resin layer at a wavelength of 550 nm is not particularly limited, and may be appropriately selected according to the intended purpose. The transmittance of the resin layer is preferably 80% or greater, more preferably 85% or greater, and yet more preferably 90% or greater. The transmittance of the resin layer at a wavelength of 550 nm can be measured by a spectrophotometer (e.g., U-4100, manufactured by Hitachi, Ltd.).

<Other layers>

The laminate further includes, in addition to the glass layer and the resin layer, other layers as necessary. Examples of the other layers in the laminate include a coupling agent layer, an adhesive layer, a transparent conductive layer, a hard coating layer, and the like.

<<Coupling agent layer>>

The coupling agent layer is preferably a layer disposed between the glass layer and the resin layer, and more preferably a layer in contact with the glass layer. The coupling agent layer can be formed, for example, by curing a coupling agent on the glass layer.

The coupling agent constituting the coupling agent layer is not particularly limited, and may be appropriately selected according to the intended purpose. Examples of the coupling agent include amino group-containing coupling agents, epoxy group-containing coupling agents, epoxy-group terminated coupling agents, isocyanate group-containing coupling agents, vinyl group-containing coupling agents, mercapto group-containing coupling agents, (meth)acryloxy group-containing coupling agents, and the like. The above coupling agents may be used alone or in combination of two or more.

In the embodiment of the present invention, the "(meth)acryloxy group" means an "acryloxy group" or a "methacryloxy group".

In the case where the resin layer includes the thermoplastic resin including an ester bond (e.g., the thermoplastic

resin (A) or the thermoplastic resin (B), or both the thermoplastic resin (A) and the thermoplastic resin (B)), the coupling agent constituting the coupling agent layer is preferably an amino group-containing coupling agent, an epoxy group-containing coupling agent, or an isocyanate group-containing coupling agent. A substitution site at which a substituent of the above coupling agent is present may be a terminal of a molecule or may not be a terminal. When the resin layer that includes the thermoplastic resin including the ester bond and the glass layer are disposed only via the coupling agent layer formed of the above coupling agent (i.e., without an adhesive layer), the resin layer that includes the thermoplastic resin including an ester bond can be strongly adhered to the glass layer via the coupling agent layer. It is assumed that an amino group, an epoxy group, or an isocyanate group in the coupling agent forms a chemical bond with the resin layer or interacts with the resin layer, and a silyl group in the coupling agent may form a chemical bond (typically a covalent bond) with a substituent (e.g., a hydroxyl group) of the glass layer. As a result, it is considered that the above-described strong adhesion can be achieved.

In the case where the resin layer includes the thermoplastic resin including a hydroxyl group (e.g., the thermoplastic resin (C)), the coupling agent constituting the coupling agent layer is preferably an epoxy-group terminated coupling agent. When the resin layer that includes the thermoplastic resin including the hydroxyl group and the glass layer are disposed only via the coupling agent layer formed of the above coupling agent (i.e., without an adhesive layer), the resin layer that includes the thermoplastic resin including the hydroxyl group is strongly adhered to the glass layer via the coupling agent layer. It is assumed that an epoxy group in the coupling agent forms a chemical bond with the resin layer or interacts with the resin layer, and a silyl group in the coupling agent may form a chemical bond with a substituent (e.g., a hydroxyl group) of the glass layer. As a result, it is considered that the above-described strong adhesion can be achieved.

Examples of the amino group-containing coupling agent include alkoxysilane including an amino group, halogenated silane including an amino group, and the like. The amino group-containing coupling agent is preferably alkoxysilane including an amino group.

Specific examples of the alkoxysilane including an amino group include 3-aminopropyltrimethoxysilane, 3-aminopropylmethyldimethoxysilane, 3-aminopropyldimethylmethoxysilane, 3-aminopropyltriethoxysilane, 3-aminopropylmethyldiethoxysilane, 3-aminopropylmethyldimethoxysilane, 6-aminohexyltrimethoxysilane, 6-aminohexyltriethoxysilane, 11-aminoundecyltrimethoxysilane, 11-aminoundecyltriethoxysilane, 3-triethoxysilyl-N-(1, 3-dimethyl-butylidene) propylamine, and the like.

Specific examples of the halogenated silane including an amino group include 3-aminopropyltrichlorosilane, 3-aminopropylmethyldichlorosilane, 3-aminopropyldimethylchlorosilane, 6-aminohexyltrichlorosilane, 11-aminoundecyltrichlorosilane, and the like.

Specific examples of the epoxy group-containing coupling agent and the epoxy-group terminated coupling agent include 2-(3, 4-epoxycyclohexyl)ethyltrimethoxysilane, 3-glycidoxypropyltrimethoxysilane, 3-glycidoxypropylmethyldiethoxysilane, 3-glycidoxypropyltriethoxysilane, and the like.

Specific examples of the isocyanate group-containing coupling agent include 3-isocyanatepropyltriethoxysilane.

Specific examples of the vinyl group-containing coupling agent include vinyltrichlorosilane, vinyl tris($\beta$-methoxyethoxy)silane, vinyltriethoxysilane, vinylmethoxysilane, $\gamma$-methacryloxypropyltrimethoxysilane, and the like.

Specific examples of the mercapto group-containing coupling agent include mercaptomethyldimethylethoxysilane, (mercaptomethyl)methyldiethoxysilane, $\gamma$-mercaptopropylmethyldimethoxysilane, $\gamma$-mercaptopropyltrimethoxysilane, $\gamma$-mercaptopropyltriethoxysilane, and the like.

Specific examples of the (meth)acryloxy group-containing coupling agent include $\gamma$-(meth)acryloxypropyltrimethoxysilane, $\gamma$-(meth)acryloxypropyltriethoxysilane, $\gamma$-(meth)acryloxypropylmethyldimethoxysilane, $\gamma$-(meth)acryloxypropylmethyldiethoxysilane, and the like.

The coupling agent may be synthesized by an appropriate method known in the related art, or a commercially available product may be used.

Examples of the commercially available amino group-containing coupling agent include: a product name "KBM-602" (N-2-(aminoethyl)-3-aminopropylmethyldimethoxysilane), a product name "KBM-603" (N-2-(aminoethyl)-3-aminopropyltrimethoxysilane), a product name "KBE-603" (N-2-(aminoethyl)-3-aminopropyltriethoxysilane), a product name "KBM-903" (3-aminopropyltrimethoxysilane), a product name "KBE-903" (3-aminopropyltriethoxysilane), a product name "KBM-573" (N-phenyl-3-aminopropyltrimethoxysilane), and a product name "KBE-9103" (3-triethoxytriethoxysilyl-N-(1, 3-dimethyl-butylidene)propylamine), manufactured by Shin-Etsu Chemical Co., Ltd.; and the like.

Examples of the commercially available epoxy group-containing coupling agent (and epoxy-group terminated coupling agent) include: a product name "KBM-303" (2-(3, 4-epoxycyclohexyl)ethyltrimethoxysilane), a product name "KBM-403" (3-glycidoxypropyltrimethoxysilane), a product name "KBE-402" (3-glycidoxypropylmethyldiethoxysilane), a product name "KBE-403" (3-glycidoxypropyltriethoxysilane), manufactured by Shin-Etsu Chemical Co., Ltd.; and the like.

Examples of the commercially available isocyanate group-containing coupling agent include a product name "KBE-9007" (3-isocyanatepropyltriethoxysilane) manufactured by Shin-Etsu Chemical Co., Ltd.

An average thickness of the coupling agent layer is not particularly limited, and may be appropriately selected according to the intended purpose, as long as the effects of the present invention are not adversely affected. The average

thickness of the coupling agent layer is preferably 0.001 μm to 10 μm, and more preferably 0.001 μm to 2 μm.

<<Adhesive layer>>

The adhesive layer is preferably a layer for adhering the glass layer and the resin layer to each other. In addition, the laminate of the embodiment of the present invention may include a coupling agent layer between the glass layer and the adhesive layer or between the adhesive layer and the resin layer.

A material constituting the adhesive layer is not particularly limited, and may be appropriately selected according to the intended purpose. Examples of the material constituting the adhesive layer include curable resins that are cured by heat or active energy rays, and the like. Specific examples of such resins include: cyclic ethers including an epoxy group, a glycidyl group, an oxetanyl group, or the like; silicone-based resins; acrylic resins; mixtures of the foregoing; and the like.

In addition, the adhesive layer may include a coupling agent. In the case where the adhesive layer includes the coupling agent, adhesion to the glass layer or the resin layer, or both the glass layer and the resin layer (the coupling agent layer or the resin layer, or both the coupling agent layer and the resin layer, in the case where the laminate includes the coupling agent layer) can be improved.

An average thickness of the adhesive layer is not particularly limited, and may be appropriately selected according to the intended purpose, as long as the effect of the present invention is not adversely affected. The average thickness of the adhesive layer is preferably 10 μm or less, more preferably 0.01 μm to 10 μm, and yet more preferably 0.1 μm to 7 μm. When the average thickness of the adhesive layer is 10 μm or less, excellent adhesion between the glass layer and the resin layer can be realized without impairing the flexibility of the laminate.

<<Transparent conductive layer>>

The transparent conductive layer is preferably disposed over a surface of the resin layer, and the surface is an opposite side to the surface of the resin layer to which the glass layer is disposed. When the laminate of the embodiment of the present invention is used as a substrate of a display element or a solar cell, the transparent conductive layer can function as an electrode or an electromagnetic wave shield.

A material constituting the transparent conductive layer is not particularly limited, and may be appropriately selected according to the intended purpose, as long as the material has conductivity. Examples of the material constituting the transparent conductive layer include: metals such as copper and silver; metal oxides, such as indium tin oxide (ITO) and indium zinc oxide (IZO); conductive polymers, such as polythiophene and polyaniline; compositions including carbon nanotubes; and the like. The above materials may be used alone or in combination.

An average thickness of the transparent conductive layer is not particularly limited, and may be appropriately selected according to the intended purpose, as long as the effects of the present invention are not adversely affected.

<<Hard coating layer>>

The hard coating layer is disposed over a surface of the resin layer, and the surface is an opposite side to the surface of the resin layer on which the glass layer is disposed. The hard coating layer has a function of imparting chemical resistance, scratch resistance, and surface smoothness to the laminate of the embodiment of the present invention.

A material constituting the hard coating layer is not particularly limited, and may be appropriately selected according to the intended purpose. Examples of the material constituting the hard coating layer include epoxy-based resins, acrylic resins, silicone-based resins, and any mixture of the foregoing. The above materials may be used alone or in combination of two or more. Among above materials, an epoxy-based resin, which excels in heat resistance, is preferable. The hard coating layer can be obtained by curing any of the above resins by heat or active energy rays.

<Production method>

A production method for the laminate of the embodiment of the present invention is not particularly limited, and may be appropriately selected according to the intended purpose. Examples of the production method include: a method in which a resin layer is formed on a glass layer by solution coating to obtain a laminate (may be referred to as "Production Method Embodiment Example 1" hereinafter); a method in which a resin film is adhered onto a glass layer to form a resin layer, thereby obtaining a laminate (may be referred to as "Production Method Embodiment Example 2" hereinafter); and the like.

<<Production Method Embodiment Example 1>>

The method in which the resin layer is formed on the glass layer by solution coating to obtain a laminate preferably

includes a coating step, a drying step, and a heat treatment step, and more preferably further includes a coupling treatment step. The coating step is a step of applying a solution including a material constituting a resin layer to one or both surfaces of a glass layer by coating to form a coating layer. The drying step is a step of drying the coating layer. The heat treatment step is a step of performing a heat treatment on the dried coating layer to form a resin layer. The coupling treatment step is a step of performing a coupling treatment on the surface of the glass layer. The material constituting the resin layer is as described in the above section of <Resin layer>.

-Coating step-

A coating solvent used in the coating step is not particularly limited, and may be appropriately selected according to the intended purpose. Examples of the coating solvent include: halogen-based solvents, such as methylene chloride, ethylene chloride, chloroform, carbon tetrachloride, and trichloroethane; aromatic solvents, such as toluene, benzene, and phenol; cellosolve-based solvents, such as methyl cellosolve and ethyl cellosolve; ether-based solvents, such as propylene glycol monomethyl ether and ethylene glycol monoisopropyl ether; ketone-based solvents, such as methyl ethyl ketone, methyl isobutyl ketone, cyclopentanone, and cyclohexanone; and the like. The above solvents may be used alone or in combination of two or more. Among the above coating solvent, the coating solvent used in the coating step is preferably a halogen-based solvent, an aromatic solvent, a cellosolve-based solvent, or an ether-based solvent because adhesion between the resin layer and the glass layer is sufficiently maintained at high temperatures and high humidity, and a laminate having excellent durability and reliability can be obtained.

The coating method for the solution including the material constituting the resin layer is not particularly limited, and may be appropriately selected according to the intended purpose. Examples of the coating method include: coating, such as air doctor coating, blade coating, knife coating, reverse coating, transfer roll coating, gravure roll coating, kiss coating, cast coating, spray coating, slot orifice coating, calender coating, electrodeposition coating, dip coating, and die coating; printing, such as relief printing (e.g. flexographic printing), intaglio printing (e.g., direct gravure printing and offset gravure printing), planographic printing (e.g., offset printing), and stencil printing (screen printing); and the like.

-Drying step-

As the drying step, any appropriate drying method (e.g., natural drying, air drying, and heat drying) can be applied. In the case of heat drying, a drying temperature is preferably 100°C to 200°C, and a drying time is preferably 1 minute to 10 minutes.

-Heat treatment step-

As the heat treatment step, any appropriate heat treatment method can be applied. A heat treatment temperature is preferably 100°C to 300°C, and a heat treatment time is preferably 5 minutes to 45 minutes. In the case where the laminate of the embodiment of the present invention includes the coupling agent layer, the heat treatment step can allow the coupling agent and the resin included in the resin layer to form a chemical bond or to cause an interaction.

-Coupling treatment step-

The coupling treatment step, which is a step of performing a coupling treatment on the surface of the glass layer, is preferably included before the coating step. By performing the coupling treatment and forming a coupling agent layer on the surface of the glass layer, the resin layer can be strongly adhered to the glass layer via the coupling agent layer. The material constituting the coupling agent layer used in the coupling treatment step is as described in the above section of <Coupling agent layer>.

As the coupling treatment method, any appropriate method may be used. Specifically, examples of the coupling treatment method include a method in which a solution including a coupling agent is applied onto a surface of a glass layer by coating, followed by performing a heat treatment.

The solvent used for preparation of the solution including the coupling agent is not particularly limited as long as the solvent does not react with the coupling agent, and any appropriate solvent can be used. Specific examples of the solvent used for preparation of the solution including the coupling agent include: aliphatic hydrocarbon-based solvents, such as hexane and hexadecane; aromatic solvents, such as benzene, toluene, and xylene; halogen hydrocarbon-based solvents, such as methylene chloride and 1,1,2-trichloroethane; ether-based solvents, such as tetrahydrofuran and 1,4-dioxane; alcohol-based solvents, such as methanol and propanol; ketone-based solvents, such as acetone and 2-butanone; water; and the like. The above solvents may be used alone or in combination of two or more.

As the heat treatment method at the time of the coupling treatment, any appropriate heat treatment method can be used. A heat treatment temperature is preferably 50°C to 150°C, and a heat treatment time is preferably 1 minute to 10

minutes. The heat treatment allows the coupling agent and the surface of the glass layer to bond with each other via a chemical bond.

<<Production Method Embodiment Example 2>>

In the method in which a resin film is adhered onto a glass layer to form a resin layer, thereby forming a laminate, the resin layer may be formed by bonding a commercially available resin film onto the surface of the glass layer, or the resin layer may be formed by applying a solution of a resin onto any appropriate substrate by coating to form a resin film, followed by transferring the resin film to the surface of the glass layer, and then bonding the glass layer and the resin film.

Before binding the resin film, a surface modification may be performed on the glass layer by subjecting the surface of the glass layer to a corona treatment, a plasma treatment, an excimer treatment, a flame treatment, or the like, or a coupling treatment may be performed on the glass layer. As a method for the coupling treatment, the above-described method can be used. Among the above treatments, the corona treatment is preferably performed on the surface of the glass layer because reactive functional groups are generated at the surface of the glass layer to improve adhesion with the resin layer, foreign matter deposited on the surface of the glass layer is removed or surface irregularities are reduced by an ashing effect so that a laminate having excellent appearance can be produced.

An annealing treatment may be performed on the resin film before or after bonding the resin film onto the glass layer. By performing the annealing treatment, impurities, such as a residual solvent, an unreacted monomer component, and the like, can be efficiently removed. A temperature and time of the annealing treatment are not particularly limited, and may be appropriately selected according to the intended purpose. The temperature is preferably 100°C to 200°C, and the time is preferably 5 minutes to 20 minutes.

The resin film may be bonded to the surface of the glass layer via an adhesive layer. The adhesive layer may be formed on the resin film, followed by bonding to the glass layer. Alternatively, after forming the adhesive layer on the glass layer, the resin film may be bonded to the adhesive layer.

Examples of a formation method for the adhesive layer include a method in which a thermoset resin or an active energy ray curable resin is applied onto a glass layer or a resin film by coating, followed by bonding the glass layer and the resin film, and the thermoset resin or the active energy ray curable resin is cured by ultraviolet light irradiation or a heating treatment, and the like. The irradiation conditions of the ultraviolet light irradiation are not particularly limited. The cumulative irradiation light dose is preferably 100 $mJ/cm^2$ to 2,000 $mJ/cm^2$, and the irradiation time is preferably 5 minutes to 30 minutes. The conditions of the heat treatment are not particularly limited. The heating temperature is preferably 100°C to 200°C, and the heating time is preferably 5 minutes to 30 minutes. After applying the thermoset resin or active energy ray curable resin onto the surface of the glass layer or the resin film by coating, and before bonding the glass layer and the resin film together, the thermoset resin or active energy ray curable resin may be semi-cured. The conditions of semi-curing are not particularly limited, but the semi-curing can be performed by applying ultraviolet light of 1 $mJ/cm^2$ to 1,000 $mJ/cm^2$ for 1 second to 60 seconds.

Configuration embodiments of the laminate of the embodiment of the present invention will be concretely described with reference to drawings, hereinafter.

[[Configuration Embodiment Example 1]]

Fig. 1 is a schematic cross-sectional view illustrating an example of the laminate of the embodiment of the present invention. The laminate 100a includes the glass layer 10 and the resin layer 11 disposed over at least one surface or both surfaces, preferably both surfaces, of the glass layer 10.

[[Configuration Embodiment Example 2]]

Fig. 2 is a schematic cross-sectional view illustrating another example of the laminate of the embodiment of the present invention. The laminate 100b is different from Configuration Embodiment Example 1 in that a coupling agent layer 12 is disposed between the glass layer 10 and the resin layer 11.

[[Configuration Embodiment Example 3]]

Fig. 3 is a schematic cross-sectional view illustrating another example of the laminate of the embodiment of the present invention. The laminate 100c is different from Configuration Embodiment Example 1 in that the laminate 100c includes an adhesive layer 13 disposed between the glass layer 10 and the resin layer 11.

[[Configuration Embodiment Example 4]]

Fig. 4 is a schematic cross-sectional view illustrating another example of the laminate of the embodiment of the present invention. The laminate 100d includes the glass layer 10, and the coupling agent layer 12, the adhesive layer 13, and the resin layer 11 in this order on at least one surface or both surfaces, preferably both surfaces, of the glass layer 10.

In the laminate of the embodiment of the present invention, the glass layer 10 and the resin layer 11 may be disposed via the coupling agent layer 12 as illustrated in Fig. 2 (glass layer 10/coupling agent layer 12/resin layer 11), or may be disposed via the adhesive layer 13 as illustrated in Fig. 3 (glass layer 10/adhesive layer 13/resin layer 11). The laminate of the present invention may include the coupling agent layer 12 and the adhesive layer 13, where the glass layer 10, the coupling agent layer 12, the adhesive layer 13, and the resin layer 11 may be disposed in this order as illustrated in Fig. 4. Preferably, the coupling agent layer 12 is formed directly on the glass layer 10. More preferably, the glass layer 10 and the resin layer 11 are disposed only via the coupling agent layer 12 (glass layer 10/coupling agent layer 12/resin layer 11). With such a configuration, the glass layer 10 and the resin layer 11 can be strongly adhered to each other so that a laminate that has excellent dimensional stability, inhibits warping, and is less likely to develop cracks can be obtained.

The coupling agent layer preferably forms a chemical bond (typically, a covalent bond) with the glass layer. As a result, a laminate having excellent adhesion between the glass layer and the coupling agent layer can be obtained.

The resin layer or the adhesive layer preferably forms a chemical bond (typically a covalent bond) with the coupling agent layer, or interacts with the coupling agent layer. As a result, a laminate having excellent adhesion between the coupling agent layer and the resin layer or the adhesive layer can be obtained.

<Use>

The laminate of the embodiment of the present invention is suitably used as a substrate for nanoimprint.

(Optical component)

The optical component of the embodiment of the present invention includes the laminate of the embodiment of the present invention, and may further include other members, as necessary. The laminate of the embodiment of the present invention is as described in the section of (Laminate).

<Other members>

Other members in the optical component of the embodiment of the present invention are not particularly limited as long as the effects of the present invention are not adversely affected. Examples of the other members include known members typically used for optical components, and the like.

<Production method>

The production method for the optical component of the embodiment of the present invention is not particularly limited as long as the laminate of the embodiment of the present invention is used. The optical component is suitably produced by the below-described production method for the optical component according to the embodiment of the present invention.

<Use>

The optical component of the embodiment of the present invention is suitably used for display elements or solar cells. Examples of the display elements include liquid crystal displays, plasma displays, organic EL displays, and the like.

(Imprinting method)

The imprinting method according to the embodiment of the present invention includes a transferring step, and may further include other steps, such as a curing step, a releasing step, and the like, as necessary. The transferring step is a step of pressing a recess-and-projection portion, which an imprint mold structure has, against a surface of the resin layer of the laminate of the embodiment of the present invention, which is an opposite side to a surface of the resin layer on which the glass layer is disposed, to transfer a recess-and-projection pattern corresponding to the recess-and-projection portion of the imprint mold structure to the resin layer.

<Transferring step>

The transferring step is a step of pressing a recess-and-projection portion, which an imprint mold structure has, against a surface of the resin layer of the laminate of the embodiment of the present invention, which is an opposite side to a surface of the resin layer on which the glass layer is disposed, to transfer a recess-and-projection pattern corresponding to the recess-and-projection portion of the imprint mold structure to the resin layer.

The imprint mold structure having the recess-and-projection portion is not particularly limited, and any known imprint mold structure can be used. Examples of the imprint mold structure include master templates for bit patterned media (BPM) having fine protrusions and recesses.

The width or diameter and depth of the convex portion or concave portion in the imprint mold structure having the recess-and-projection portion are not particularly limited, and may be appropriately selected according to a type of the optical component to be produced.

In the case where the material constituting the resin layer is a thermoplastic resin, the resin is softened by applying heat at a temperature suitable for the thermoplastic resin, and the imprint mold structure having the recess-and-projection portion is pressed against the resin layer in the softened state, so that the recess-and-projection pattern corresponding to the recess-and-projection portion of the imprint mold structure can be suitably transferred to the resin layer. In the case where the material constituting the resin layer is a curable resin that is cured by heat or active energy rays, the imprint mold structure having the recess-and-projection portion is pressed against the resin layer in an uncured state before heat or active energy rays are applied so that the recess-and-projection pattern corresponding to the recess-and-projection portion of the imprint mold structure can be suitably transferred to the resin layer.

<Curing step>

The curing step is a step of curing the resin constituting the resin layer in the state in which the imprint mold structure having the recess-and-projection portion is pressed against the resin layer of the laminate of the embodiment of the present invention.

The curing method is not particularly limited, and may be appropriately selected according to a type of the resin constituting the resin layer. Examples of the curing method include a method in which the resin is cured by heat or active energy rays, and the like.

<Releasing step>

The releasing step is a step of peeling (releasing) the imprint mold structure having the recess-and-projection portion from the resin layer after the curing step. Thus, the resin layer and the imprint mold structure having the recess-and-projection portion are separated, and the resin layer to which the recess-and-projection pattern corresponding the recess-and-projection portion of the imprint mold structure has been transferred can be obtained.

(Production method for optical component)

The production method for the optical component according to the embodiment of the present invention includes a transferring step, and may further include other steps, such as a curing step, a releasing step, and the like, as necessary. The transferring step is a step of pressing a recess-and-projection portion, which an imprint mold structure has, against a surface of the resin layer of the laminate of the embodiment of the present invention, which is an opposite side to a surface of the resin layer on which the glass layer is disposed, to transfer a recess-and-projection pattern corresponding to the recess-and-projection portion of the imprint mold structure to the resin layer.

The imprinting method of the embodiment of the present invention is suitably applied for the production method for the optical component of the embodiment of the present invention. Accordingly, the transferring step, the curing step, and the releasing step of the production method for the optical component of the embodiment of the present invention can be performed in the same manner as the transferring step, the curing step, and the releasing step of the imprinting method of the embodiment of the present invention.

The optical component produced by the production method for the optical component of the embodiment of the present invention can be suitably used for display elements or solar cells. Examples of the display elements include liquid crystal displays, plasma displays, organic EL displays, and the like. The laminate of the embodiment of the present invention inhibits warping, and therefore an optical component having excellent properties can be obtained.

Examples

The present invention will be concretely described through Examples and Comparative Examples hereinafter, but the present invention is not limited to Examples below in any way.

(Example 1)

In Example 1, a laminate 100e having the cross-sectional structure illustrated in Fig. 5 was produced by the following method.

Square inorganic glass (OA-10G, manufactured by Nippon Electric Glass Co., Ltd.) having a thickness of 100 μm, a longitudinal dimension of 6 cm, and a transverse dimension of 6 cm was used as a glass layer. After washing one surface of the glass layer with isopropyl alcohol, a corona treatment was performed.

The entire area of the surface (the surface subjected to the corona treatment) of the glass layer 10 was coated with an adhesive (epoxy-based resin (CELLOXIDE 2021P, manufactured by Daicel Corporation)) so that an average thickness of the adhesive after being cured became 3 μm. Next, a square polyimide (PI) film (UPILEX (registered trademark) 25S, manufactured by UBE CORPORATION) 11 having an average thickness of 25 μm, a longitudinal dimension of 6 cm, and a transverse dimension of 6 cm was stacked on the surface of the glass layer 10 to which the adhesive had been applied. Next, ultraviolet light (wavelength: 365 nm, intensity: 1,000 mJ/cm$^2$ or greater) was applied to the adhesive from the side of the glass layer by a high-pressure mercury-vapor lamp to cure the adhesive, thereby forming an adhesive layer 13. Thus, the laminate 100e in which the glass layer 10, the adhesive layer 13, and the resin layer 11 were stacked in this order was formed.

(Example 2)

A laminate was produced in the same manner as in Example 1, except that the square polyimide (PI) film (UPILEX (registered trademark) 25S, manufactured by UBE CORPORATION) having the average thickness of 25 μm, the longitudinal dimension of 6 cm, and the transverse dimension of 6 cm was changed to a square PET film (COSMOSHINE (registered trademark) A4360 38 μm, manufactured by TOYOBO CO., LTD.) having an average thickness of 38 μm, a longitudinal dimension of 6 cm, and a transverse dimension of 6 cm.

(Example 3)

A laminate was produced in the same manner as in Example 1, except that the square polyimide (PI) film (UPILEX (registered trademark) 25S, manufactured by UBE CORPORATION) having the average thickness of 25 μm, the longitudinal dimension of 6 cm, and the transverse dimension of 6 cm was changed to a square PET film (LUMIRROR (registered trademark) #16-F68, manufactured by TORAY INDUSTRIES, INC.) having an average thickness of 16 μm, a longitudinal dimension of 6 cm, and a transverse dimension of 6 cm.

(Example 4)

A laminate was produced in the same manner as in Example 1, except that the square polyimide (PI) film (UPILEX (registered trademark) 25S, manufactured by UBE CORPORATION) having the average thickness of 25 μm, the longitudinal dimension of 6 cm, and the transverse dimension of 6 cm was changed to a square PET film (LUMIRROR (registered trademark) #25-F66, manufactured by TORAY INDUSTRIES, INC.) having an average thickness of 25 μm, a longitudinal dimension of 6 cm, and a transverse dimension of 6 cm.

(Example 5)

A laminate was produced in the same manner as in Example 1, except that the square polyimide (PI) film (UPILEX (registered trademark) 25S, manufactured by UBE CORPORATION) having the average thickness of 25 μm, the longitudinal dimension of 6 cm, and the transverse dimension of 6 cm was changed to a square PET film (LUMIRROR (registered trademark) #6-F557, manufactured by TORAY INDUSTRIES, INC.) having an average thickness of 6 μm, a longitudinal dimension of 6 cm, and a transverse dimension of 6 cm.

(Comparative Example 1)

A laminate was produced in the same manner as in Example 1, except that the square polyimide (PI) film (UPILEX (registered trademark) 25S, manufactured by UBE CORPORATION) having the average thickness of 25 μm, the longitudinal dimension of 6 cm, and the transverse dimension of 6 cm was changed to a square PET film (COSMOSHINE (registered trademark) A4360 100 μm, manufactured by TOYOBO CO., LTD.) having an average thickness of 100 μm, a longitudinal dimension of 6 cm, and a transverse dimension of 6 cm.

<Evaluation of warping>

Warping of each of the laminates formed in Examples 1 to 5 and Comparative Example 1 was evaluated by digital image correlation (DIC analysis).

Specifically, a spray fluid (aqueous lacquer spray, manufactured by SUNDAY PAINT CO., LTD.) was sprayed onto the exposed surface of the resin layer 11 of the laminate 100e illustrated in Fig. 5, to produce a measuring sample in which a random granular pattern (speckle pattern) was provided on the surface of the resin layer 11. The measuring sample was placed in an oven having an observation window. The measuring sample was arranged in a manner such that the surface of the laminate on which the speckle pattern was provided faced the observation window. Moreover, a thermocouple was installed in the vicinity of the measuring sample in the oven. Subsequently, the state of the laminate before heating was captured as "Image 1" by a twin-lens camera equipped with an LED lamp from the outside of the observation window, while applying the light by the LED lamp, with a subset being set as an entire region of the surface of the laminate having a longitudinal dimension of 6 cm and a transverse dimension of 6 cm. Subsequently, the oven was heated, and when the thermocouple displayed 60°C, the state of the laminate after heating was captured as "Image 2" from the outside of the observation window using the twin-lens camera equipped with the LED lamp while applying light to the subset in the surface of the laminate by the LED lamp.

For each of Image 1 and Image 2 captured, the distortion in the x direction and y direction, and displacement in the z direction were analyzed using a deformation measurement/strain analysis device (StarinMaster, manufactured by LaVision). At the time of analysis, as illustrated in Fig. 6, the surface of the laminate to which the speckle pattern was provided (the region indicated with the solid line in Fig. 6) was divided into 9 as indicated with the perforated line in Fig. 6, the maximum value of the displacement in z direction was calculated in each of 9 divided values to obtain 9 maximum values, and the maximum value among the 9 maximum values of the displacement in the z direction was determined as the maximum z-displacement of the measuring sample at 60°C. The larger maximum z-displacement indicates the larger warping of the laminate caused by heating. The result of the maximum z-displacement is presented as "maximum thermal warping" in Table 1 below. In addition, the photographs of Image 2 depicting distortion based on the color meter are presented in Fig. 8.

[Table 1]

| | | Comp. Ex. 1 | Ex. 1 | Ex. 2 | Ex. 3 | Ex. 4 | Ex. 5 |
|---|---|---|---|---|---|---|---|
| Resin layer | Resin type | PET | PI | PET | PET | PET | PET |
| | Average thickness [$\mu$ m] | 100 | 25 | 38 | 26 | 25 | 6 |
| Adhesive layer | Average thickness [$\mu$m] | 3 | 3 | 3 | 3 | 3 | 3 |
| Glass layer | Average thickness [$\mu$m] | 100 | 100 | 100 | 100 | 100 | 100 |
| Average thickness ratio [Resin layer/Glass layer] | | 1.0 | 0.3 | 0.4 | 0.3 | 0.3 | 0.1 |
| Evaluation result of warping at 60°C | Maximum thermal warping [mm] | 2.04 | 0.12 | 0.22 | 0.07 | -0.07 | -0.07 |

When Examples 1 to 5 and Comparative Example 1 were compared, the maximum thermal warping of the laminates of Examples 1 to 5, in which the average thickness ratio (resin layer/glass layer) was less than 0.9, was reduced. In addition, the thinner the thickness of the resin layer, the higher the effect of inhibiting the maximum thermal warping.

For example, embodiments of the present invention include as follows.

<1> A laminate including:

a glass layer; and
a resin layer disposed over at least one surface of the glass layer, wherein a ratio (resin layer/glass layer) of an average thickness of the resin layer to an average thickness of the glass layer is less than 0.9.

<2> The laminate according to <1>,
wherein an absolute value of maximum thermal warping of the laminate in a thickness direction of the laminate at 60°C as measured by digital image correlation is less than 2 mm.
<3> The laminate according to <1> or <2>,
wherein the average thickness of the glass layer is 200 $\mu$m or less.

<4> The laminate according to any one of <1> to <3>,
wherein the laminate is a substrate for imprint.
<5> An optical component including:
the laminate according to any one of <1> to <4>.
<6> An imprinting method including:
a transferring step of pressing a recess-and-projection portion, which an imprint mold structure has, against a surface of the resin layer of the laminate according to any one of <1> to <4>, which is an opposite side to a surface of the resin layer on which the glass layer is disposed, to transfer a recess-and-projection pattern corresponding to the recess-and-projection portion of the imprint mold structure to the resin layer.
<7> A production method for an optical component, including:
a transferring step of pressing a recess-and-projection portion, which an imprint mold structure has, against a surface of the resin layer of the laminate according to any one of <1> to <4>, which is an opposite side to a surface of the resin layer on which the glass layer is disposed, to transfer a recess-and-projection pattern corresponding to the recess-and-projection portion of the imprint mold structure to the resin layer.

As described above, the present invention has been described based on the specific embodiments and examples, but these embodiments and examples are merely presented as examples, and the present invention is not limited by the embodiments and examples. The embodiments can be implemented in various other forms, and various combinations, omissions, substitutions, additions, changes, and the like can be made without departing from the gist of the invention. These embodiments and modifications thereof are included in the scope and gist of the invention, and are included in the invention described in the claims and the equivalent scope thereof.
The present international application claims priority based on Japanese Patent Application No. 2023-168647 filed on September 28, 2023, and the entire contents of Japanese Patent Application No. No. 2023-168647 are incorporated herein by reference.

INDUSTRIAL APPLICABILITY

The laminate of the embodiment of the present invention can be suitably used as a substrate for nanoimprint. In addition, the optical component including the laminate of the embodiment of the present invention can be widely used for display elements, such as liquid crystal displays, organic EL displays, and plasma displays, and solar cells.

DESCRIPTION OF REFERENCE NUMERALS

100a, 100b, 100c, 100d, 100e: laminate
10: glass layer
11: resin layer
12: coupling agent layer
13: adhesive layer

**Claims**

**1.** A laminate comprising:

a glass layer; and
a resin layer disposed over at least one surface of the glass layer,

wherein a ratio (resin layer/glass layer) of an average thickness of the resin layer to an average thickness of the glass layer is less than 0.9.

**2.** The laminate according to claim 1,
wherein an absolute value of maximum thermal warping of the laminate in a thickness direction of the laminate at 60°C as measured by digital image correlation is less than 2 mm.

**3.** The laminate according to claim 1 or 2,
wherein the average thickness of the glass layer is 200 μm or less.

**4.** The laminate according to any one of claims 1 to 3, wherein the laminate is a substrate for imprint.

**5.** An optical component comprising: the laminate according to any one of claims 1 to 4.

**6.** An imprinting method comprising: a transferring step of pressing a recess-and-projection portion, which an imprint mold structure has, against a surface of the resin layer of the laminate according to any one of claims 1 to 4, which is an opposite side to a surface of the resin layer on which the glass layer is disposed, to transfer a recess-and-projection pattern corresponding to the recess-and-projection portion of the imprint mold structure to the resin layer.

**7.** A production method for an optical component, comprising: a transferring step of pressing a recess-and-projection portion, which an imprint mold structure has, against a surface of the resin layer of the laminate according to any one of claims 1 to 4, which is an opposite side to a surface of the resin layer on which the glass layer is disposed, to transfer a recess-and-projection pattern corresponding to the recess-and-projection portion of the imprint mold structure to the resin layer.

FIG.1

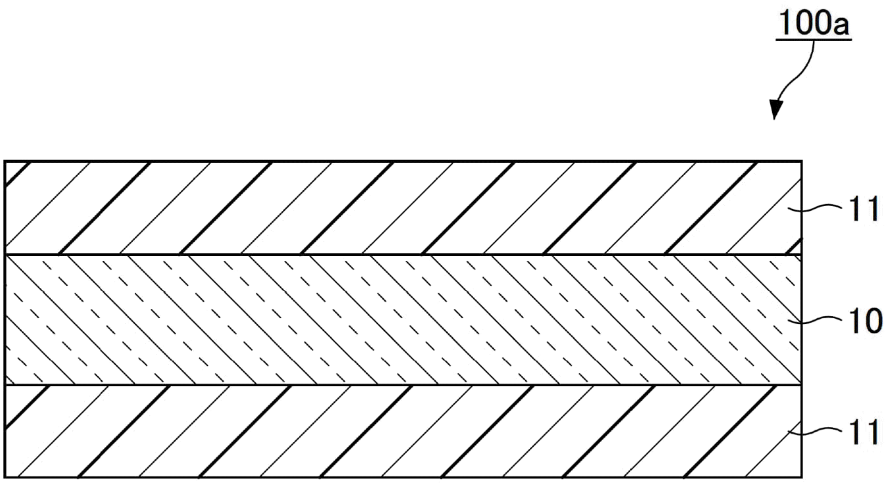


FIG.2

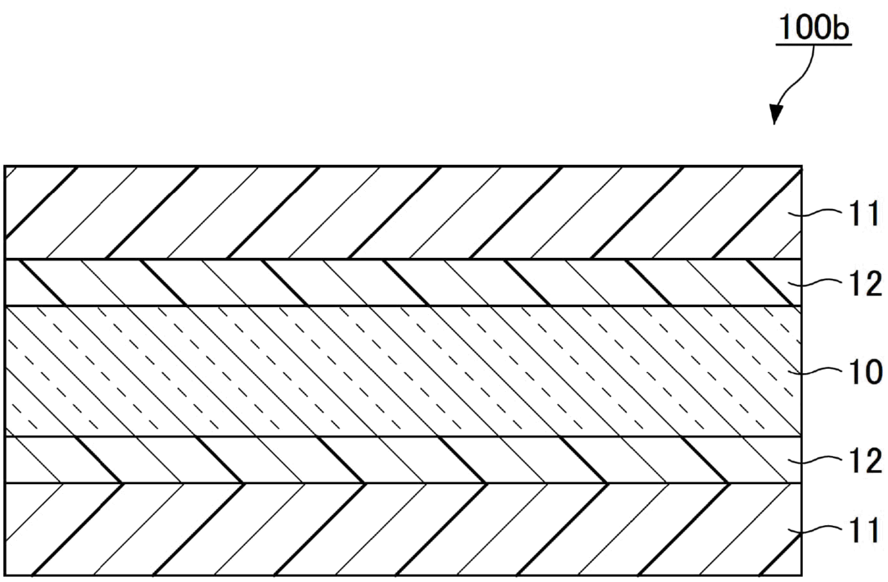

FIG.3

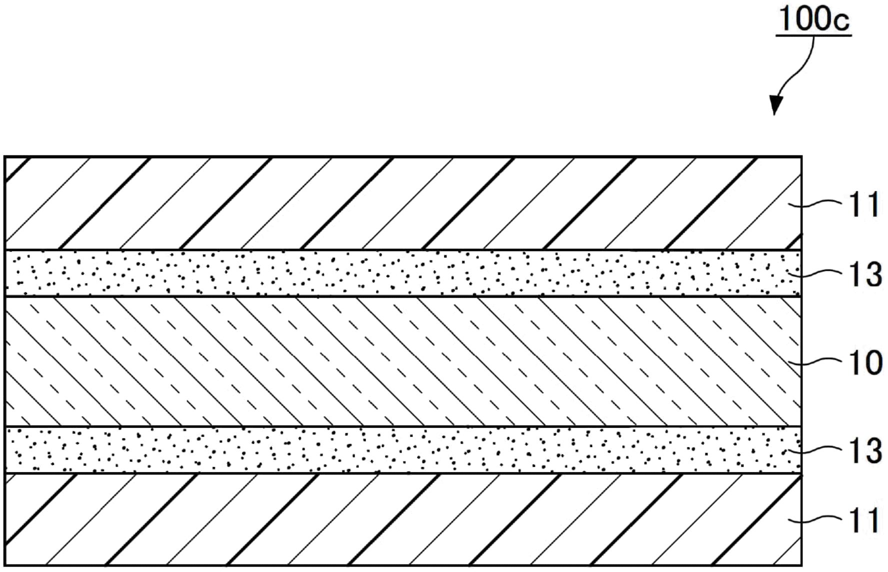


FIG.4

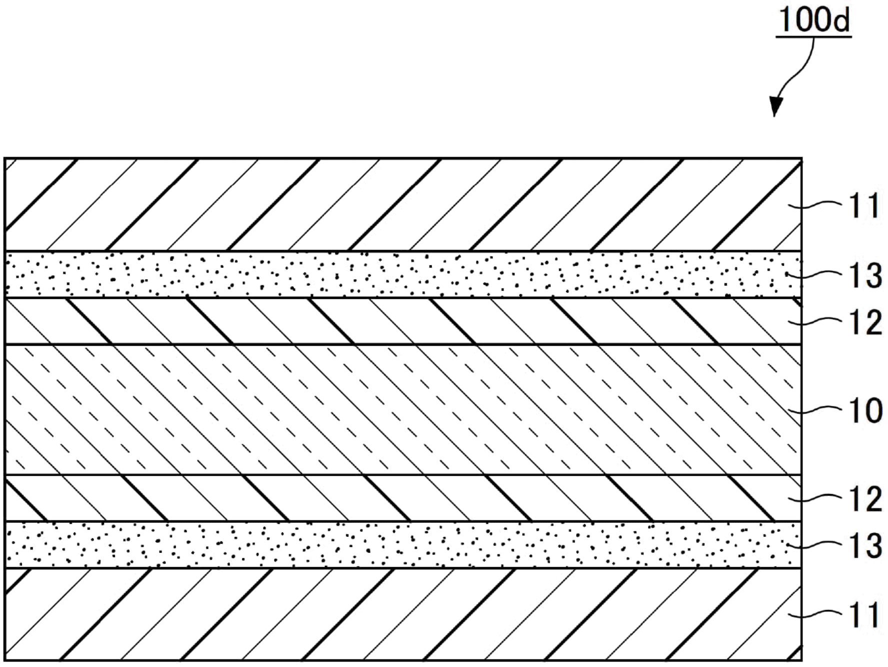

FIG.5

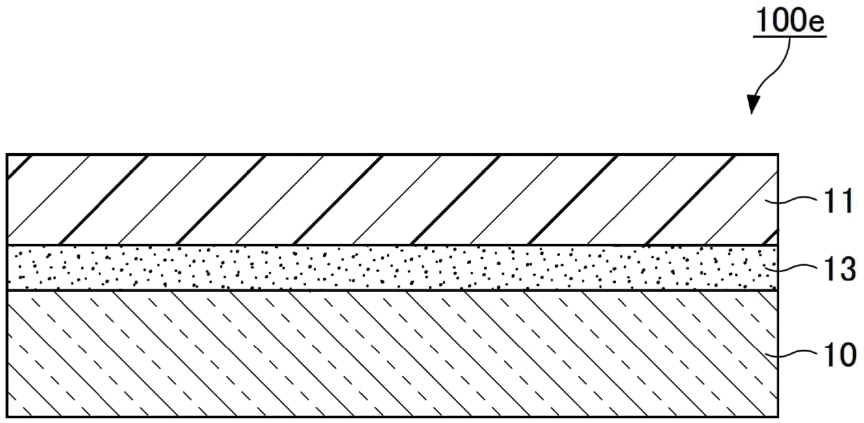


FIG.6

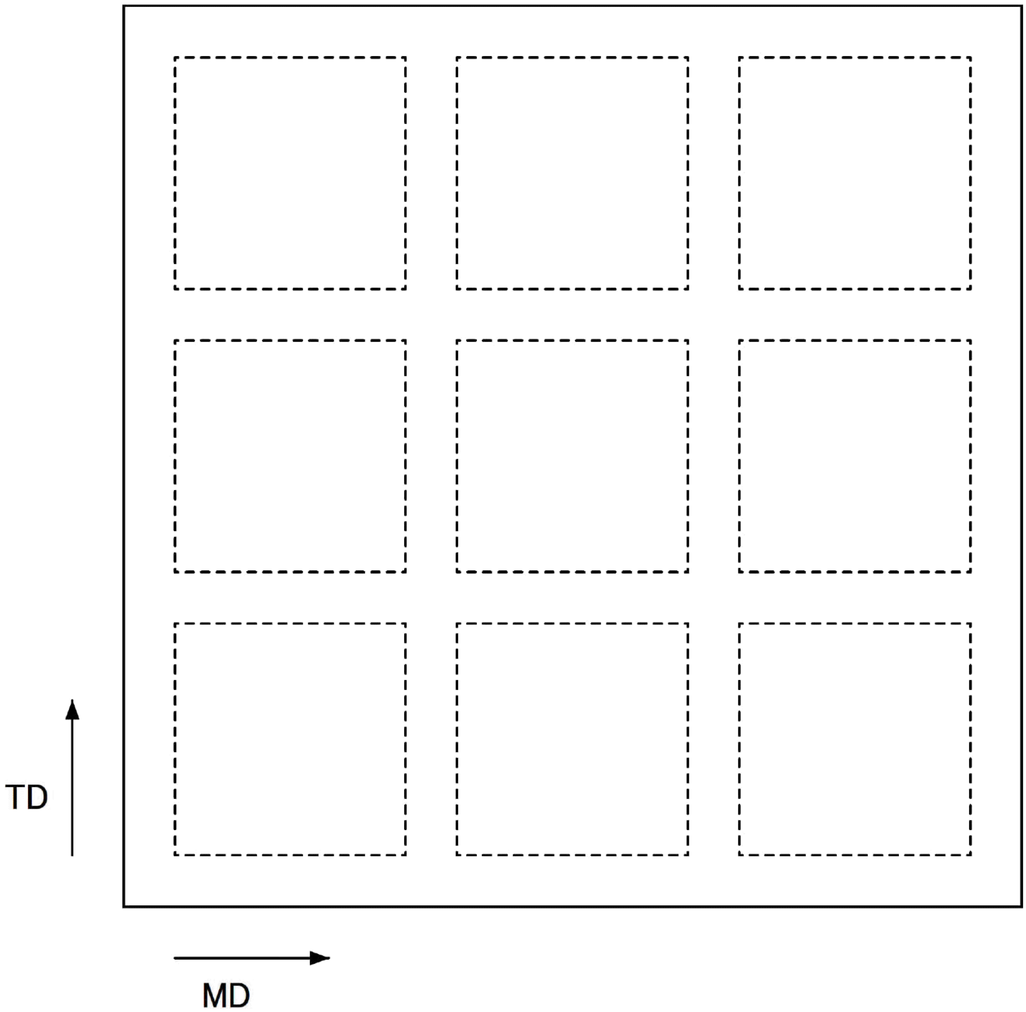

FIG.7A

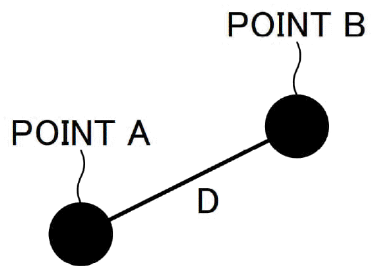
POINT B
POINT A
D

FIG.7B

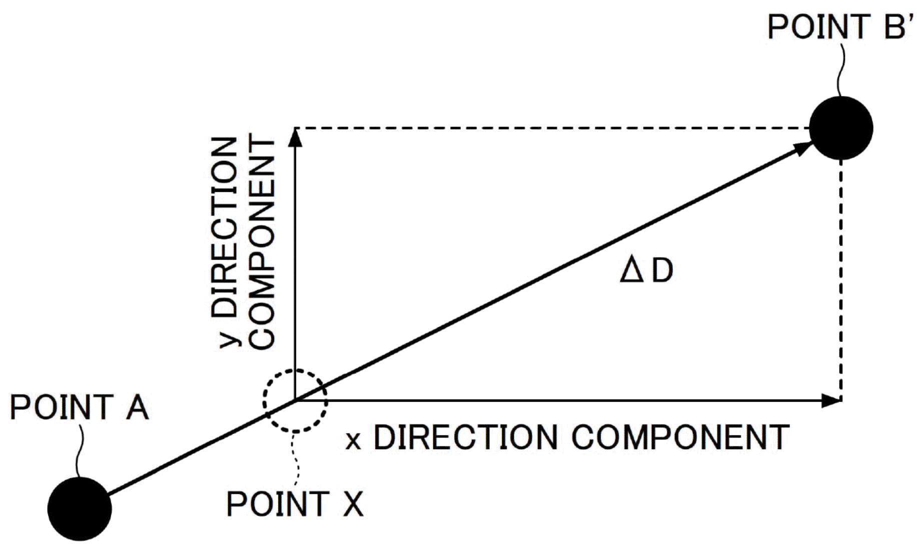
POINT B'
y DIRECTION COMPONENT
ΔD
POINT A
x DIRECTION COMPONENT
POINT X

FIG.8

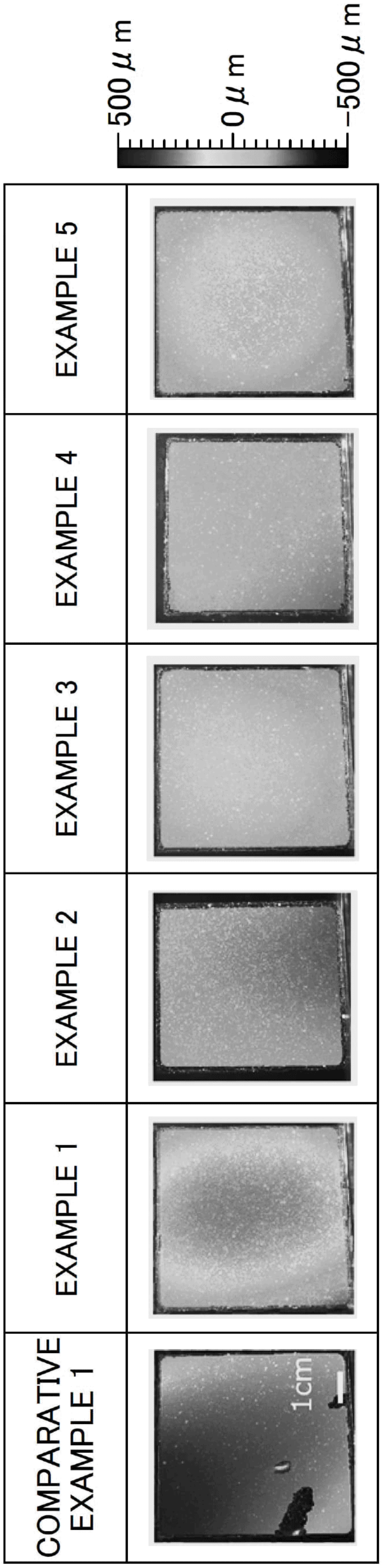
500 μ m
0 μ m
-500 μ m
COMPARATIVE EXAMPLE 1
EXAMPLE 1
EXAMPLE 2
EXAMPLE 3
EXAMPLE 4
EXAMPLE 5
1cm

## INTERNATIONAL SEARCH REPORT

International application No.
**PCT/JP2024/024992**

**A. CLASSIFICATION OF SUBJECT MATTER**

***B32B 17/10***(2006.01)i; ***H01L 21/027***(2006.01)i
FI: B32B17/10; H01L21/30 502D

According to International Patent Classification (IPC) or to both national classification and IPC

**B. FIELDS SEARCHED**

Minimum documentation searched (classification system followed by classification symbols)

B32B17/10; H01L21/027

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>A | JP 2015-217548 A (MITSUBISHI PLASTICS, INC.) 07 December 2015 (2015-12-07)<br>claims, paragraphs [0049]-[0067], example 3, table 1 | 1-3, 5<br>4, 6-7 |
| A | WO 2011/048861 A1 (NITTO DENKO CORPORATION) 28 April 2011 (2011-04-28) | 1-7 |
| A | WO 2009/131073 A1 (NITTO DENKO CORPORATION) 29 October 2009 (2009-10-29) | 1-7 |
| A | WO 2010/035783 A1 (BRIDGESTONE CORPORATION) 01 April 2010 (2010-04-01) | 1-7 |
| A | JP 2014-132669 A (FUJIFILM CORPORATION) 17 July 2014 (2014-07-17) | 1-7 |
| A | JP 2011-159924 A (FUJIFILM CORPORATION) 18 August 2011 (2011-08-18) | 1-7 |
| A | JP 2021-178405 A (AGC INC.) 18 November 2021 (2021-11-18) | 1-7 |

☐ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **24 September 2024** | **08 October 2024** |
| Name and mailing address of the ISA/JP<br>**Japan Patent Office (ISA/JP)**<br>**3-4-3 Kasumigaseki, Chiyoda-ku, Tokyo 100-8915**<br>**Japan** | Authorized officer<br><br>Telephone No. |

Form PCT/ISA/210 (second sheet) (July 2022)

**INTERNATIONAL SEARCH REPORT**
**Information on patent family members**

International application No.
**PCT/JP2024/024992**

| Patent document cited in search report | Publication date (day/month/year) | Patent family member(s) | Publication date (day/month/year) |
|---|---|---|---|
| JP 2015-217548 A | 07 December 2015 | (Family: none) | |
| WO 2011/048861 A1 | 28 April 2011 | US 2012/0196103 A1 | |
| | | EP 2492250 A1 | |
| | | CN 102574736 A | |
| | | KR 10-2012-0073286 A | |
| WO 2009/131073 A1 | 29 October 2009 | US 2011/0244225 A1 | |
| | | EP 2899170 A1 | |
| | | KR 10-2010-0125435 A | |
| | | CN 102016962 A | |
| WO 2010/035783 A1 | 01 April 2010 | US 2011/0254205 A1 | |
| | | EP 2343730 A1 | |
| | | CN 102165558 A | |
| JP 2014-132669 A | 17 July 2014 | (Family: none) | |
| JP 2011-159924 A | 18 August 2011 | (Family: none) | |
| JP 2021-178405 A | 18 November 2021 | (Family: none) | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP H11329715 A
- WO 0122165 A
- JP 2023168647 A